# EUROPEAN PATENT APPLICATION

(11) **EP 4 516 425 A1**
(43) Date of publication of application: **05.03.2025**
(21) Application number: 22939731.0
(22) Date of filing: 06.09.2022
(51) Int. Cl.: B22F 1/05, B22F 1/142, B22F 1/145, B22F 9/04, B22F 9/18, C22F 1/02, C22F 1/18

(54) **HIGH-PURITY TANTALUM POWDER AND PREPARATION METHOD THEREFOR**

(30) Priority: 29.04.2022 CN 202210466030
(71) Applicant: Ningxia Orient Tantalum Industry Co., Ltd., Shizuishan, Ningxia 753000 (CN)
(72) Inventor: LI, Hui, SHIZUISHAN, Ningxia 753000 (CN); ZHENG, Peisheng, SHIZUISHAN, Ningxia 753000 (CN); MA, Haiyan, SHIZUISHAN, Ningxia 753000 (CN); WANG, Yanjie, SHIZUISHAN, Ningxia 753000 (CN); CHEN, Xueqing, SHIZUISHAN, Ningxia 753000 (CN); ZHANG, Xueqing, SHIZUISHAN, Ningxia 753000 (CN); LIN, Fukun, SHIZUISHAN, Ningxia 753000 (CN); LUO, Guoqing, SHIZUISHAN, Ningxia 753000 (CN); MA, Yinghui, SHIZUISHAN, Ningxia 753000 (CN); LI, Xiaolong, SHIZUISHAN, Ningxia 753000 (CN); LI, Zhiqiang, SHIZUISHAN, Ningxia 753000 (CN); WANG, Xiaodong, SHIZUISHAN, Ningxia 753000 (CN); YANG, Yan, SHIZUISHAN, Ningxia 753000 (CN); XU, Jun, SHIZUISHAN, Ningxia 753000 (CN); GUI, Yuping, SHIZUISHAN, Ningxia 753000 (CN)
(74) Representative: Boult Wade Tennant LLP
(86) International application number: PCT/CN2022/117279
(87) International publication number: WO 2023/206905

(57) **Abstract**

A high-purity tantalum powder and a preparation method therefor. The sum of W, Mo and Nb content of the high-purity tantalum powder is less than 0.6 ppm, Mg content is less than 1 ppm, and oxygen content is less than 600 ppm. The high-purity tantalum powder can be used to prepare a high-purity tantalum target.

## Description

### Cross-reference

The present application claims the priority to the Chinese patent application No. 202210466030.6 filed on Apr. 29, 2022, which is incorporated herein by reference in its entirety.

### Technical Field

The present application belongs to the field of metal smelting, and particularly relates to a high-purity tantalum powder and a preparation method therefor.

### Background Art

Tantalum is an important rare refractory metal material. It has good heat resistance, corrosion resistance and oxidation resistance, and excellent atomic migration resistance, and is a preferred sputtering target material for a barrier layer of a semiconductor chip with an integrated circuit line width below 45 nm. A manufacturing method of a high-purity tantalum target comprises the following steps: smelting a high-purity tantalum powder into a high-purity tantalum ingot with an electron beam, and performing thermal mechanical processing to obtain the high-purity tantalum target.

In the process of manufacturing the high purity tantalum ingot from the high-purity tantalum powder, some refractory metals such as W, Mo and Nb are difficult to remove. Thus, there is a need to provide a high-purity tantalum powder with a low content of metal impurities.

### Contents of the Invention

It is difficult to reduce a content of refractory metals (e.g., W, Mo, Nb), magnesium content, and oxygen content. On one hand, refractory metals are not easily removed by refining. On the other hand, to obtain a tantalum powder with a low oxygen content, magnesium powder must be used for oxygen reduction operation, but the operation will increase the magnesium content in the tantalum powder.

In view of the above problems, the present application provides a novel type of high-purity tantalum powder and a preparation method therefor. The tantalum powder prepared by the method of the present application has a significantly reduced content of metal impurities, particularly, a reduced content of refractory metals (e.g., W, Mo, Nb), magnesium and oxygen.

In some embodiments, the present application provides a preparation method for a high-purity tantalum powder having a sum of the contents of W, Mo and Nb < 0.6 ppm, magnesium content < 1 ppm and oxygen content < 600 ppm, comprising the steps of:
1) providing a tantalum raw powder, the tantalum raw powder having a sum of the contents of W, Mo and Nb of less than 0.6 ppm;
2) performing a first crushing on the tantalum raw powder to obtain a first crushed tantalum powder, the first crushed tantalum powder having a bulk density of more than 2.6 g/cm³ (for example, 2.6-6 g/cm³, such as 2.68 g/cm³, 2.8 g/cm³, 2.9 g/cm³, 3 g/cm³, 4 g/cm³ or 5 g/cm³);
3) carrying out a first pickling on the first crushed tantalum powder to obtain a first pickled tantalum powder;
4) carrying out a vacuum heat treatment on the first pickled tantalum powder, and passivating the tantalum powder after the vacuum heat treatment to obtain a passivated tantalum powder;
5) doping a metal reducing agent into the passivated tantalum powder, then performing an oxygen reduction heat treatment, and thereafter passivating powder and discharing the passivated powder out of the furnace to obtain an oxygen-reduced powder;
6) performing a second crushing on the oxygen-reduced powder, until the powder can pass through a sieve with 5-15 meshes (for example, a sieve with 10 meshes) to obtain a second crushed powder;
7) carrying out a second pickling on the second crushed powder to obtain a second pickled tantalum powder;
8) washing and drying the second pickled tantalum powder.

In some embodiments, the vacuum heat treatment is performed at an absolute pressure value of 3×10⁻³ Pa or less.

In some embodiments, the sum of the contents of W, Mo, Nb elements in the tantalum raw powder is less than 0.6 ppm, such as less than 0.4 mm, such as less than 0.3 mm.

In the above embodiment, it is critical that the sum of the contents of W, Mo and Nb in the tantalum raw powder is less than 0.6 ppm, which helps to reduce the contents of W, Mo and Nb from the source, thereby obtaining a product with a low content of W, Mo and Nb.

In the above embodiment, it is critical that the first crushed tantalum powder has a bulk density of more than 2.6 g/cm³. Based on this, W, Mo and other impurities contained in the tantalum powder particles are released, which is convenient for further improving the purity in the later stage.

In the above embodiment, the first pickling is critical, and functions to remove contaminants such as Fe, Ni, Cr and other impurities from the surface of the tantalum powder and remove a part of refractory impurities W, Mo, Nb, thereby improving the purity of the product.

In the above embodiment, the vacuum heat treatment functions to remove the gas impurities adsorbed during the pickling process and part of the low melting point metal impurities, and at the same time, it can promote the agglomeration and sintering of part of the particles.

In the above embodiment, it is critical that the second crushed tantalum powder can pass through a sieve with 5-15 meshes. Since the oxygen reduction process is a solid-liquid two-phase redox reaction, magnesium serving as a reducing agent is easily included and wrapped by tantalum powder, so that magnesium impurities cannot be effectively removed during subsequent pickling purification, and the resulting tantalum powder has a high content of metal magnesium impurities. Upon careful study, the inventor finds that the addition of a reasonable crushing process after discharging the powder from the furnace for oxygen reduction treatment can crush the particles and effectively open the tantalum particles that wrap and include magnesium, which provides favorable conditions for subsequent pickling purification to remove metal magnesium.

In the above embodiment, the second pickling is critical, and functions to remove contaminants such as Fe, Ni, Cr and other impurities from the surface of the tantalum powder and remove a part of refractory impurities W, Mo, Nb, thereby improving the purity of the product.

In some embodiments, the equipment for performing the first crushing operation may be a ball mill such as a planetary ball mill, a vibratory ball mill, a tumble ball mill. When the crushing equipment is a ball mill, the ball-to-material ratio is 0.4-1: 1, for example.

In some embodiments, the equipment for performing the second crushing operation may be a jaw crusher, a cone crusher, a counter impact crusher.

In some embodiments, the preparation method for a high-purity tantalum powder according to the present application further comprises the step of reducing a tantalum-containing salt with a reducing agent to obtain a tantalum raw powder;
the purity of the reducing agent is ≥ 99.9%;
the sum of the contents of W, Mo and Nb in the tantalum-containing salt is less than 1 ppm. The use of the tantalum-containing salt having a sum of the contents of W, Mo and Nb of less than 1.0 ppm, as the raw material, is beneficial to reducing the contents of W, Mo and Nb in high-purity tantalum powder products.

Optionally, the reducing agent is sodium;
optionally, the tantalum-containing salt is potassium fluotantalate.

In some embodiments, the step 2) has one or more of the following characteristics:
- the pickling solution used in the first pickling contains 5-30 wt% of HNO₃ and 0.5-5 wt% of HF;
- the pickling time is 1-5 h.

In some embodiments, in the step 4), the vacuum heat treatment is performed using a heat treatment furnace in which tantalum or a tantalum alloy is used as a heating belt and a heat shield. It is beneficial to avoid the impurity pollution caused by the heat treatment furnace to the heat treated tantalum powder.

In some embodiments, the vacuum heat treatment comprises sequentially:
a first temperature heat treatment, i.e., keeping at the temperature of 800-1000°C for 0.5-3 h; and
a second temperature heat treatment, i.e., keeping at the temperature of 1000-1550°C for 0.5-3 h.

In some embodiments, the step 7) has one or more of the following characteristics:
- the pickling solution used in the second pickling contains 5-15 wt% of HNO₃ and 0.2-2 wt% of HF;
- the pickling time is 2-4 h.

In some embodiments, after the first temperature heat treatment, the second temperature heat treatment is performed by increasing the temperature from the first temperature to the second temperature at a ramp of 5 to 20°C/min.

In some embodiments, the step 5) has one or more of the following characteristics:
the temperature of the oxygen reduction heat treatment is 850-960°C;
the time of the oxygen reduction heat treatment is 1-3 h.

In some embodiments, the high-purity tantalum powder has a Fischer particle size of 5.0-15.0 µm.

In some embodiments, the high-purity tantalum powder has a bulk density of 2.6-6.0 g/cm³.

In a second aspect, the present application provides a manufacturing method of a high-purity tantalum target, comprising the steps of:
- preparing a high-purity tantalum powder according to the method of any one of claims 1 to 9;
- smelting the high-purity tantalum powder into a high-purity tantalum ingot;
- processing the high-purity tantalum ingot into the high-purity tantalum target.

In some embodiments, the present application provides a high-purity tantalum powder.

In some embodiments, the high-purity tantalum powder has a purity of ≥ 99.998%.

In some embodiments, the high-purity tantalum powder has an oxygen content < 600 ppm.

In some embodiments, the high-purity tantalum powder has a sum of the contents of W, Mo, Nb < 0.6 ppm.

In some embodiments, the high-purity tantalum powder has a sum of the contents of W, Mo, Nb < 0.4 ppm.

In some embodiments, the high-purity tantalum powder has a sum of the contents of W, Mo < 0.2 ppm.

In some embodiments, the high-purity tantalum powder has a sum of the contents of W, Mo < 0.1 ppm, and Nb content < 0.4 ppm, preferably < 0.3 ppm.

In some embodiments, the high-purity tantalum powder has an O content of 390-510 ppm.

In some embodiments, the high-purity tantalum powder has a C content of 7-8 ppm.

In some embodiments, the high-purity tantalum powder has an N content of 20-49 ppm.

In some embodiments, the high-purity tantalum powder has a Fe content of 2.49-8.04 ppm.

In some embodiments, the high-purity tantalum powder has a Ni content of 1.21-2.85 ppm.

In some embodiments, the high-purity tantalum powder has a Cr content of 1.34-2.67 ppm.

In some embodiments, the high-purity tantalum powder has a K content of 0.42-1.19 ppm.

In some embodiments, the high-purity tantalum powder has a Na content of 2.78-6.14 ppm.

In some embodiments, the high-purity tantalum powder has a Si content of 0.91-4.16 ppm.

In some embodiments, the high-purity tantalum powder has a W content of 0.016-0.057 ppm.

In some embodiments, the high-purity tantalum powder has a Mo content of 0.034-0.035 ppm.

In some embodiments, the high-purity tantalum powder has a Nb content of 0.087-0.22 ppm.

In some embodiments, the high-purity tantalum powder has a Mg content of 0.53-0.94 ppm.

In some embodiments, the high-purity tantalum powder has an O content of 510 ppm or less.

In some embodiments, the high-purity tantalum powder has a C content of 8 ppm or less.

In some embodiments, the high-purity tantalum powder has a N content of 49 ppm or less.

In some embodiments, the high-purity tantalum powder has a Fe content of 8.04 ppm or less.

In some embodiments, the high-purity tantalum powder has a Ni content of 2.85 ppm or less.

In some embodiments, the high-purity tantalum powder has a Cr content of 2.67 ppm or less.

In some embodiments, the high-purity tantalum powder has a K content of 1.19 ppm or less.

In some embodiments, the high-purity tantalum powder has a Na content of 6.14 ppm or less.

In some embodiments, the high-purity tantalum powder has a Si content of 4.16 ppm or less.

In some embodiments, the high-purity tantalum powder has a W content of 0.057 ppm or less.

In some embodiments, the high-purity tantalum powder has a Mo content of 0.035 ppm or less.

In some embodiments, the high-purity tantalum powder has a Nb content of 0.22 ppm or less.

In some embodiments, the high-purity tantalum powder has a Mg content of 0.94 ppm or less.

In some embodiments, the high-purity tantalum powder is prepared by any one of the methods described above.

In some embodiments, the high-purity tantalum powder has a Fischer particle size of 5.0-15.0 µm;
in some embodiments, the high-purity tantalum powder has a bulk density of 2.6-6.0 g/cm³.

In some embodiments, the high-purity tantalum powder refers to a tantalum powder having a sum of the contents of W, Mo, Nb < 0.6 ppm, Mg content < 1 ppm, and oxygen content < 600 ppm.

High-purity tantalum metal preferably can be prepared by reacting a tantalum-containing salt with at least one reducing agent (e.g., a compound or element) that is capable of reducing the tantalum-containing salt to tantalum metal while producing a second salt in a reaction vessel. The reaction vessel may be any vessel commonly used for metal reactions, and should be able to withstand elevated temperatures of about 800°C to about 1200°C. For the purposes of the present application, the reaction vessel or its liner, which is in contact with the tantalum-containing salt and the reducing agent capable of reducing the salt to tantalum, is made of a material whose vapor pressure at the melting point of tantalum is the same as or higher than that of tantalum. The stirrer inside the reaction vessel may be made of the same material or may be lined with the same material. The liner may be present only on the parts of the reaction vessel and the stirrer that are in contact with the salt and tantalum. Examples of such metal materials that may be used to constitute the liner or reaction vessel include, but are not limited to, metal-based materials made from the following metals: nickel, chromium, iron, manganese, titanium, zirconium, hafnium, vanadium, ruthenium, cobalt, rhodium, palladium, platinum, or combinations thereof, or alloys thereof, as long as the vapor pressure of the alloy material at the melting point of tantalum is the same or higher than that of tantalum. Preferably the metal material is nickel or nickel based alloy, chromium or chromium based alloy, or iron or iron based alloy. If a liner is present on the reaction vessel and/or the stirrer, it is generally from about 0.5 cm to about 3 cm thick. Liners of other thicknesses can also be used. Multilayer liners made of the same or different metal materials described above are also included within the scope of the present application.

The tantalum-containing salt may be any salt that enables tantalum to be contained therein, such as potassium tantalum fluoride (potassium fluotantalate). As the reducing agent capable of reducing the tantalum-containing salt to tantalum and a second salt in the reaction vessel, any reducing agent capable of effecting such reduction may be used, which may be just sufficient to reduce the tantalum-containing salt to tantalum metal and other components (e.g., salts) separable from the tantalum metal, for example, the salts can be dissolved with water or other water source. Preferably, the reducing agent is sodium. Typically, the second salt formed simultaneously upon the reduction of the tantalum-containing salt is sodium fluoride. In the present application, details of the reduction method applicable to the present application are described in Kirk-Othmer, «Encyclopedia of Chemical Engineering», 3rd Edition, Vol. 22, pp. 541-564; U.S. patents 2950185; 3829310; 4149876, and 3767456. More details regarding tantalum processing method can be found in U.S. patents 5234491; 5242481, and 4684399. All of these patents and publications are incorporated herein by reference in their entirety.

### Interpretation of terms:

In the present specification, the unit ppm means "parts per million" in mass ratio unless otherwise specifically stated.

In one embodiment, the Fischer particle size (FSSS/µm) is determined according to the method specified in Standard «Method for Determination of Particle Size of Refractory Metal and Compound Powders - Fischer Method» (Standard No. GB/T3249-2009).

In one embodiment, the bulk density (SBD) is determined according to the method specified in Standard «Determination of Bulk Density of Metal Powders Part I Funnel Method» (Standard No. GB/T1479.1-2011).

In one embodiment, O, N, H in tantalum powder are determined according to the methods specified in «GB/T15076.13-2017 Tantalum Niobium Chemical Analysis Method Part 13: Determination of Nitrogen Content Inert Melting Thermal Conductivity Method», «GB/T15076.4-2017 Tantalum Niobium Chemical Analysis Method Part 14: Determination of Oxygen Content Inert Melting Infrared Absorption Method», «GB/T15076.12-2017 Tantalum Niobium Chemical Analysis Method Part 15: Determination of Hydrogen Content Inert Melting Thermal Conductivity Method», and other impurity elements are determined according to the method specified in «YS/T899-2013 High-Purity Tantalum Chemical Analysis Method Determination of Trace Impurity Elements Glow Discharge Mass Spectrometry».

In one embodiment, when the particle size of the powder is expressed in mesh number, the sign "+" or "-" before the mesh number indicates "not passing" or "passing" through a screen with the mesh number, respectively. For example, "-100 mesh" means passing through a screen with 100 meshes, and "+150 meshes" means not passing through a screen with 150 meshes. Therefore, "-100 ~ +150 meshes" indicates that the powder passes through a screen with 100 meshes and does not pass through a screen with 150 meshes.

### Advantageous effects

One or more technical solutions of the present disclosure have one or more of the following beneficial effects:
(1) the tantalum powder of the present application has a higher purity and a lower impurity content;
(2) the preparation method for the tantalum powder according to the present application has the advantages of low cost, simple process, high efficiency and easy large-scale production.

### Detailed Description of Embodiments

Embodiments of the present application will be described in detail below with reference to the examples, but it will be understood by those skilled in the art that the following examples are only illustrative of the present application and should not be construed as limiting the scope of the present application. The examples, in which specific conditions are not specified, were carried out according to conventional conditions or conditions recommended by the manufacturer. The reagents or equipment used, for which the manufacturer is not indicated, are all conventional products commercially available.

### Example 1

(1) Potassium fluotantalate (with a sum of the contents of W, Mo and Nb of less than 1.0 ppm) was reduced by a sufficient amount of sodium (with a purity ≥ 99.9%), and the reduction product was crushed into reduction material blocks with a size of about 1 cm. The reduction material blocks were first leached by pure water for about 24 h until the conductivity of leached solution was lower than 500 us/cm, then pickled by a pickling solution containing 2.0 wt% of HF and 15 wt% of HNO₃ with stirring for 3 h, then placed aside for soaking for 1 h, and then repeatedly rinsed and suction-filtered by pure water, and dried (120°C/14 h) in vacuum to obtain a tantalum raw powder, the tantalum raw powder having a sum of the contents of W, Mo and Nb of 0.250 ppm.
(2) First crushing: the tantalum raw powder was mixed with stainless steel balls with a diameter of about 20 mm according to the mass ratio of 2: 1, and the resulting mixture was added into a ball mill to carry out ball milling for 40 min, to obtain a first crushed tantalum powder with a bulk density of 2.68 g/cc.
(3) The first crushed tantalum powder was subjected to a first pickling by a pickling solution containing 15 wt% of HNO₃ and 0.5 wt% of HF with stirring for 2 h, then placed aside for soaking for 1 h, and then repeatedly rinsed and suction-filtered by pure water, and dried (120°C/14 h) in vacuum to obtain a first pickled tantalum powder.
(4) The first pickled tantalum powder was placed into a vacuum heat treatment furnace which employed tantalum material as a heating belt and a heat shield, and subjected to a vacuum heat treatment comprising: keeping at the temperature of 900°C for 1 h, then increasing the temperature to 1200°C at a ramp of 15°C/min, and then keeping at this temperature for 2 h, thereafter the powder was passivated and discharged out of the furnace, and passed through a screen with 50 meshes to obtain a heat-treated tantalum powder.
(5) The heat-treated tantalum powder was doped with magnesium powder at a doping amount of 1.0 wt%, and placed into a heating furnace, then the heating furnace was vacuumized and filled with argon, heated to 930°C, and kept at this temperature for 3 h to carry out oxygen reduction reaction. Then, the heating furnace was vacuumized for removing magnesium for 2 h, thereafter the powder was passivated and discharged out of the furnace, to obtain an oxygen-reduced powder.
(6) The oxygen-reduced powder was subjected to a second crushing by using a crusher until the crushed product could pass through a sieve with 10 meshes to obtain a second crushed powder;
(7) The second crushed powder was subjected to a second pickling by a pickling solution containing 0.2 wt% of HF and 15 wt% of HNO₃ with stirring for 2 h, and placed aside for soaking for 1 h to obtain a second pickled tantalum powder.
(8) The second pickled tantalum powder was repeatedly rinsed and suction-filtered by pure water, dried (120°C/14 h) in vacuum, and passed through a screen with 50 meshes to obtain Sample 1. The chemical impurities and physical properties of the sample are shown in Table 1.

### Example 2

(1) Potassium fluotantalate (with a sum of the contents of W, Mo and Nb of less than 1.0 ppm) was reduced by a sufficient amount of sodium (with a purity ≥ 99.9%), and the reduction product was crushed into reduction material blocks with a size of about 1 cm. The reduction material blocks were first leached by pure water for about 24 h until the conductivity of leached solution was lower than 500 us/cm, then pickled by a pickling solution containing 2.0 wt% of HF and 15 wt% of HNO₃ with stirring for 3 h, then placed aside for soaking for 1 h, and then repeatedly rinsed and suction-filtered by pure water, and dried (120°C/14 h) in vacuum to obtain a tantalum raw powder, the tantalum raw powder having a sum of the contents of W, Mo and Nb of 0.200 ppm.
(2) The tantalum raw powder was mixed with stainless steel balls with a diameter of about 15 mm according to the mass ratio of 2: 1, and the resulting mixture was added into a ball mill to carry out ball milling for 40 min, to obtain a first crushed tantalum powder with a bulk density of 3.0 g/cm³.
(3) The first crushed tantalum powder was subjected to a first pickling by a pickling solution containing 15 wt% of HNO₃ and 0.5 wt% of HF with stirring for 2 h, then placed aside for soaking for 1 h, and then repeatedly rinsed and suction-filtered by pure water, and dried (120°C/14 h) in vacuum to obtain a first pickled tantalum powder.
(4) The first pickled tantalum powder was placed into a vacuum heat treatment furnace which employed tantalum material as a heating belt and a heat shield, and subjected to a vacuum heat treatment comprising: keeping at the temperature of 900°C for 1 h, then increasing the temperature to 1200°C at a ramp of 15°C/min, and then keeping at this temperature for 2 h, thereafter the powder was passivated and discharged out of the furnace, and passed through a screen with 50 meshes to obtain a heat-treated tantalum powder.
(5) The heat-treated tantalum powder was doped with magnesium powder at a doping amount of 0.8 wt%, and placed into a heating furnace, then the heating furnace was vacuumized and filled with argon, heated to 930°C, and kept at this temperature for 3 h to carry out oxygen reduction reaction. Then, the heating furnace was vacuumized for removing magnesium for 2 h, thereafter the powder was passivated and discharged out of the furnace, to obtain an oxygen-reduced powder.
(6) The oxygen-reduced powder was subjected to a second crushing by using a crusher until the crushed product could pass through a sieve with 10 meshes to obtain a second crushed powder;
(7) The second crushed powder was subjected to a second pickling by a pickling solution containing 0.2 wt% of HF and 15 wt% of HNO₃ with stirring for 2 h, and placed aside for soaking for 1 h to obtain a second pickled tantalum powder.
(8) The second pickled tantalum powder was repeatedly rinsed and suction-filtered by pure water, dried (120°C/14 h) in vacuum, and passed through a screen with 50 meshes to obtain Sample 2. The chemical impurities and physical properties of the sample are shown in Table 1.

### Example 3

(1) Potassium fluotantalate (with a sum of the contents of W, Mo and Nb of less than 1.0 ppm) was reduced by a sufficient amount of sodium (with a purity ≥ 99.9%), and the reduction product was crushed into reduction material blocks with a size of about 1 cm. The reduction material blocks were first leached by pure water for about 24 h until the conductivity of leached solution was lower than 500 us/cm, then pickled by a pickling solution containing 2.0 wt% of HF and 15 wt% of HNO₃ with stirring for 3 h, then placed aside for soaking for 1 h, and then repeatedly rinsed and suction-filtered by pure water, and dried (120°C/14 h) in vacuum to obtain a tantalum raw powder, the tantalum raw powder having a sum of the contents of W, Mo and Nb of 0.160 ppm.
(2) The tantalum raw powder was mixed with stainless steel balls with a diameter of about 15 mm according to the mass ratio of 2: 1, and the resulting mixture was added into a ball mill to carry out ball milling for 40 min, to obtain a first crushed tantalum powder with a bulk density of 2.9 g/cm³.
(3) The first crushed tantalum powder was subjected to a first pickling by a pickling solution containing 15 wt% of HNO₃ and 0.5 wt% of HF with stirring for 2 h, then placed aside for soaking for 1 h, and then repeatedly rinsed and suction-filtered by pure water, and dried (120°C/14 h) in vacuum to obtain a first pickled tantalum powder.
(4) The first pickled tantalum powder was placed into a vacuum heat treatment furnace which employed tantalum material as a heating belt and a heat shield, and subjected to a vacuum heat treatment comprising: keeping at the temperature of 900°C for 1 h, then increasing the temperature to 1250°C at a ramp of 15°C/min, and then keeping at this temperature for 2 h, thereafter the powder was passivated and discharged out of the furnace, and passed through a screen with 50 meshes to obtain a heat-treated tantalum powder.
(5) The heat-treated tantalum powder was doped with magnesium powder at a doping amount of 0.7 wt%, and placed into a heating furnace, then the heating furnace was vacuumized and filled with argon, heated to 930°C, and kept at this temperature for 3 h to carry out oxygen reduction reaction. Then, the heating furnace was vacuumized for removing magnesium for 2 h, thereafter the powder was passivated and discharged out of the furnace, to obtain an oxygen-reduced powder.
(6) The oxygen-reduced powder was subjected to a second crushing by using a crusher until the crushed product could pass through a sieve with 10 meshes to obtain a second crushed powder;
(7) The second crushed powder was subjected to a second pickling by a pickling solution containing 0.2 wt% of HF and 15 wt% of HNO₃ with stirring for 2 h, and placed aside for soaking for 1 h to obtain a second pickled tantalum powder.
(8) The second pickled tantalum powder was repeatedly rinsed and suction-filtered by pure water, dried (120°C/14 h) in vacuum, and passed through a screen with 50 meshes to obtain Sample 3. The chemical impurities and physical properties of the sample are shown in Table 1.

### Comparative Example 1

The process conditions of Comparative Example 4 are the same as those of Example 1 except only that the step (2) is not included.

### Comparative Example 2

The process conditions of Comparative Example 4 are the same as those of Example 1 except only that the step (6) is not included.

### Analysis and determination

(1) The Fischer particle size (FSSS/µm) was determined according to the method specified in Standard «Method for Determination of Particle Size of Refractory Metal and Compound Powders - Fischer Method» (Standard No. GB/T3249-2009).
(2) The bulk density (SBD) was determined according to the method specified in Standard «Determination of Bulk Density of Metal Powders Part I Funnel Method» (Standard No. GB/T1479.1-2011).
(3) O, N, H in tantalum powder were determined according to the methods specified in China National Standards «GB/T15076.13-2017 Tantalum Niobium Chemical Analysis Method Part 13: Determination of Nitrogen Content Inert Melting Thermal Conductivity Method», «GB/T15076.4-2017 Tantalum Niobium Chemical Analysis Method Part 14: Determination of Oxygen Content Inert Melting Infrared Absorption Method», «GB/T15076.12-2017 Tantalum Niobium Chemical Analysis Method Part 15: Determination of Hydrogen Content Inert Melting Thermal Conductivity Method», and other impurity elements were determined according to the method specified in «YS/T899-2013 High-Purity Tantalum Chemical Analysis Method Determination of Trace Impurity Elements Glow Discharge Mass Spectrometry».

The chemical impurities and physical properties of the samples are shown in Table 1.

**Table 1 Chemical impurities and physical properties of the samples**

| Sample No. | Content of chemical impurities/ppm | | | | | | | | | | | | | | Physical properties of tantalum powder | |
|---|---|---|---|---|---|---|---|---|---|---|---|---|---|---|---|---|
| | O | C | N | Fe | Ni | Cr | K | Na | Si | W | Mo | Nb | Mg | Purity | FSSS µm | SBD g/cm³ |
| Example 1 | 390 | 8 | 49 | 2.49 | 1.43 | 1.34 | 1.19 | 5.18 | 0.91 | 0.016 | 0.034 | 0.22 | 0.69 | 4N8 | 9.64 | 3.01 |
| Example 2 | 440 | 7 | 20 | 8.04 | 2.85 | 2.67 | 0.42 | 6.14 | 4.16 | 0.056 | 0.035 | 0.13 | 0.53 | 4N8 | 7.18 | 4.8 |
| Example 3 | 510 | 7 | 32 | 3.94 | 1.21 | 1.36 | 0.43 | 2.78 | 3.2 | 0.057 | 0.034 | 0.087 | 0.94 | 4N8 | 5.02 | 3.42 |
| Comparative Example 1 | 420 | 15 | 55 | 5.24 | 1.49 | 3.45 | 5.66 | 4.62 | 6.71 | 0.210 | 0.180 | 0.310 | 1.2 | <4N8 | 6.68 | 3.59 |
| Comparative Example 2 | 400 | 10 | 40 | 3.24 | 3.49 | 2.45 | 1.66 | 3.62 | 2.71 | 0.180 | 0.160 | 0.270 | 4.9 | <4N8 | 8.64 | 3.27 |

From the above data, it can be seen that the high-purity tantalum powder obtained by the method of the present application has a sum of the contents of refractory impurities W, Mo and Nb < 0.6 ppm, Mg content < 1 ppm, and oxygen content < 600 ppm, which can meet the requirements for use of high purity tantalum products.

As can be seen from comparison between Examples 1-3 and Comparative Example 1, the first crushing operation of the step (2) and the second crushing operation of the step (6) in Examples 1-3 are very critical. The first crushing operation results in a first crushed tantalum powder with a bulk density of 2.6-6 g/cm³, and impurity elements in the first crushed tantalum powder are effectively removed by the first pickling. The second crushing operation results in a tantalum powder that can pass through a sieve with 10 meshes, and impurity elements, particularly magnesium element, in the second crushed tantalum powder are effectively removed by the second pickling. The combination of the above features effectively improves the purity of the high-purity tantalum powder in Examples 1-3, so that the obtained high-purity tantalum powder has a sum of the contents of W, Mo and Nb < 0.6 ppm, and Mg content < 1 ppm.

The tantalum powder obtained in Comparative Example 1, which excludes the first crushing operation, has a sum of the contents of W, Mo and Nb up to 0.7 ppm.

The tantalum powder obtained in Comparative Example 2, which excludes the second crushing operation, has a Mg content of 4.9 ppm.

Although specific embodiments of the disclosure have been described in detail, those skilled in the art will understand that: according to all the teachings that have been disclosed, various changes can be made to the details, and these changes are all within the scope of protection of the disclosure. The full scope of the disclosure is given by the appended claims and any equivalents thereof.

## Claims

1. A preparation method for a high-purity tantalum powder, a sum of the contents of W, Mo and Nb of the high-purity tantalum powder being < 0.6 ppm, magnesium content of the high-purity tantalum powder being < 1 ppm and oxygen content of the high-purity tantalum powder being < 600 ppm, wherein the preparation method for the high-purity tantalum powder comprises the steps of:
1) providing a tantalum raw powder, the tantalum raw powder having a sum of the contents of W, Mo and Nb of less than 0.6 ppm;
2) performing a first crushing on the tantalum raw powder to obtain a first crushed tantalum powder, the first crushed tantalum powder having a bulk density of more than 2.6 g/cm³;
3) carrying out a first pickling on the first crushed tantalum powder to obtain a first pickled tantalum powder;
4) carrying out a vacuum heat treatment on the first pickled tantalum powder, and passivating the tantalum powder after the vacuum heat treatment to obtain a passivated tantalum powder;
5) doping a metal reducing agent into the passivated tantalum powder, then performing an oxygen reduction heat treatment, and thereafter passivating powder and discharging the passivated powder out of the furnace to obtain an oxygen-reduced powder;
6) performing a second crushing on the oxygen-reduced powder, until the powder can pass through a sieve with 5-15 meshes to obtain a second crushed powder;
7) carrying out a second pickling on the second crushed powder to obtain a second pickled tantalum powder;
8) washing and drying the second pickled tantalum powder.

2. The preparation method for the tantalum powder as claimed in claim 1, wherein further comprising a step of reducing a tantalum-containing salt with a reducing agent to obtain a tantalum raw powder, wherein,
(1) the purity of the reducing agent is ≥ 99.9%; and
(2) the sum of the contents of W, Mo and Nb in the tantalum-containing salt is less than 1 ppm;
optionally, the reducing agent is sodium;
optionally, the tantalum-containing salt is potassium fluotantalate.

3. The preparation method for the tantalum powder as claimed in claim 1, wherein the step 3) has one or more of the following characteristics:
- the pickling solution used in the first pickling contains 5-30 wt% of HNO₃ and 0.5-5 wt% of HF;
- the pickling time is 1-5 h.

4. The preparation method for the tantalum powder as claimed in claim 1, wherein in the step 4), the vacuum heat treatment is performed using a heat treatment furnace in which tantalum or a tantalum alloy is used as a heating belt and a heat shield.

5. The preparation method for the tantalum powder as claimed in claim 1, wherein the vacuum heat treatment comprises sequentially:
a first temperature heat treatment, i.e., keeping at the temperature of 800-1000°C for 0.5-3 h; and
a second temperature heat treatment, i.e., keeping at the temperature of 1000-1550°C for 0.5-3 h.

6. The preparation method for the tantalum powder as claimed in claim 1, wherein the step 7) has one or more of the following characteristics:
- the pickling solution used in the second pickling contains 5-15 wt% of HNO₃ and 0.2-2 wt% of HF;
- the pickling time is 2-4 h.

7. The preparation method for the tantalum powder as claimed in claim 1, wherein after the first temperature heat treatment, the second temperature heat treatment is performed by increasing the temperature from the first temperature to the second temperature at a ramp of 5 to 20°C/min.

8. The preparation method for the tantalum powder as claimed in claim 1, wherein the step 5) has one or more of the following characteristics:
the temperature of the oxygen reduction heat treatment is 850-960°C;
the time of the oxygen reduction heat treatment is 1-3 h.

9. The preparation method for the tantalum powder as claimed in claim 1, wherein which has one or more of the following characteristics:
- the high-purity tantalum powder has a Fischer particle size of 5.0-15.0 µm.
- the high-purity tantalum powder has a bulk density of 2.6-6.0 g/cm³.

10. A manufacturing method of a high-purity tantalum target, comprising the steps of:
- preparing a high-purity tantalum powder according to the method of any one of claims 1 to 9;
- smelting the high-purity tantalum powder into a high-purity tantalum ingot;
- processing the high-purity tantalum ingot into the high-purity tantalum target.

11. A high-purity tantalum powder prepared according to the method of any one of claims 1 to 9.

12. A high-purity tantalum powder having a purity of ≥ 99.998%, wherein the tantalum powder has an oxygen content < 600 ppm, a sum of the contents of W, Mo, Nb < 0.6 ppm, and a sum of the contents of W, Mo < 0.2 ppm;
optionally, the high-purity tantalum powder is prepared according to the method of any one of claims 1 to 9.

13. The high-purity tantalum powder as claimed in claim 12, which has one or more of the following characteristics:
- the high-purity tantalum powder has a Fischer particle size of 5.0-15.0 µm.
- the high-purity tantalum powder has a bulk density of 2.6-6.0 g/cm³.
